# EUROPEAN PATENT APPLICATION

(11) **EP 1 808 893 A2**
(43) Date of publication of application: **18.07.2007**
(21) Application number: 06122121.4
(22) Date of filing: 11.10.2006
(51) Int. Cl.: H01L 27/02

(54) **Protective circuit with antenna diode**

(30) Priority: 12.01.2006 US 330882
(71) Applicant: Honeywell International Inc., Morristown, New Jersey 07962 (US)
(72) Inventor: Carlson, Roy M., Plymouth, MN Minnesota 55447 (US); Golke, Keith W., Minneapolis, MN Minnesota 55408 (US)
(74) Representative: Haley, Stephen

(57) **Abstract**

An antenna diode circuit is described. The antenna diode circuit includes two diodes connected in series between a signal line and ground. Alternatively, the antenna diode circuit is connected in series between a signal line and a power supply. In addition to protecting the signal line from charge accumulation during wafer fabrication, the antenna diode circuit prevents a single event transient glitch caused by a particle strike to either one of the diodes in the antenna diode circuit.

## Description

The United States Government has acquired certain rights in this invention pursuant to Contract No. DTRA01-02-D-0008 awarded by the Defense Threat Reduction Agency.

The present invention relates generally to antenna diodes, and more particularly, relates to an antenna diode circuit that is immune from single effect transients (SET).

During wafer processing, a charge may develop on deposited metal signal lines. If too much charge accumulates on the metal lines, the accumulated charge may damage transistors fabricated on the wafer. For example, the accumulated charge may damage a PN junction and/or a polysilicon gate of a transistor. Thus, a need exists to discharge the metal lines during processing to avoid transistor damage. One method for discharging the accumulated charge is connecting a diode between the metal line and ground. A diode that is used to discharge a metal line during fabrication is referred to as an "antenna diode."

The antenna diode is often placed at the end of a long route, near a gate of a transistor. Automated computer aided drafting (CAD) programs are typically used to place antenna diodes in a device layout. One such program for inserting antenna diodes is described in U.S. Patent No. 6,594,809 ("the '809 patent"). As described in the '809 patent, diodes are formed in unconnected pairs that are selectively connected to each other and to an adjacent conductor in order to correct antenna rule violations. When connected, a diode pair is connected in series between a voltage source VSS and a voltage drain VDD, as well as to the signal line to be protected from accumulated charge.

However, an antenna diode is a potential source of SET and the CAD programs inserting antenna diodes into a device layout do not take into account the effects of SET. A Single Event Effect (SEE) is a disturbance in an active electronic device caused by a single, energetic particle. One type of SEE is a Single Event Upset (SEU). An SEU is a radiation-induced error in a semiconductor device caused when a charged particle loses energy by ionizing the medium through which it passes, leaving behind a wake of electron-hole pairs, forming a parasitic conduction path. The parasitic conduction path causes a false transition on a node. The false transition, or glitch, propagates through the semiconductor device and ultimately results in the disturbance, of a node containing state information, such as an output of a latch or register.

Typically, an SEU is caused by ionizing radiation components in the atmosphere, such as neutrons, protons, and heavy ions. The ionizing radiation components are abundant in space, even at commercial flight altitudes. Additionally, an SEU can be caused by alpha particles from the decay of trace concentrations of uranium and thorium present in some integrated circuit packaging. As another example, an SEU may be caused by a detonated nuclear weapon. When a nuclear weapon is detonated, intense fluxes of gamma rays, x-rays, and other high energy particles are created.

One type of SEE is SET. A SET may occur when a particle strikes a sensitive region within a logic circuit. A voltage disturbance produced in that region may cause parasitic current to flow, which may cause a voltage transient to appear on a node of the logic circuit. Depending on the circuit design, the transient voltage may propagate through the logic, possible causing an erroneous output. The erroneous output could impact the proper operation of a system that includes the circuit.

Some semiconductor devices are designed to operate in conditions that expose the devices to energetic particles. An antenna diode may be placed on a signal line that is driven by a circuit that has been designed to be SET immune. There may be a significant interconnect resistance between the antenna diode and the drain of the driving transistor. A particle strike on a reverse biased PN junction diode may cause a current to flow in the diode, potentially causing a significant noise glitch at the end of the line. Thus, the insertion of the antenna diode may introduce an SET weakness to a circuit that has been hardened against SET.

For example, the antenna diode design described in the '809 patent may introduce an SET weakness to a circuit hardened against SEU. When the diode pair is connected as described in the '809 patent, a particle hit on either diode could cause an SET on the connected signal line. Thus, the antenna diode design described in the '809 patent is unsuitable for circuit designs that need to be hardened against radiation.

Therefore, it would be beneficial to have an antenna diode design that is immune from SET. As a result, an antenna diode circuit can be used to protect a signal line from accumulating charge during fabrication, without introducing an SET weakness to a circuit connected to the signal line.

An antenna diode circuit is described. The antenna diode circuit includes a first diode having a first cathode and a first anode, and a second diode having a second cathode and a second anode. The first cathode is connected to a signal line, the second cathode is connected to the first anode, and the second anode is connected to ground. Alternatively, the first cathode is connected to a power supply, such as VDD, the first anode is connected to the second cathode, and the second anode is connected to the signal line. Moreover, two antenna diode circuits may be used. The first antenna diode circuit may be connected between the signal line and ground, and the second antenna diode circuit may be connected between the signal line and the power supply.

The signal line is a metal line that needs to be protected against charge accumulation during fabrication. The signal line may be driven by a circuit that is hardened against SET. A device layout program may insert the antenna diode circuit on a signal line that exceeds a predefined ratio of metal area to polysilicon gate area. The first diode and the second diode may be located on a wafer so as to minimize a single particle passing through both the first and second diodes. In addition to protecting the signal line from charge accumulation during wafer fabrication, the antenna diode circuit prevents an SET glitch caused by a particle strike to either one of the first and second diodes in the antenna diode circuit.

A method for protecting a metal line from charge accumulation during fabrication is also described. Beneficially, the method does not introduce an SET weakness to a circuit connected to the metal line. The method includes connecting a first cathode of a first diode to the metal line, connecting a second cathode of a second diode to a first anode of the first diode, and connecting a second anode of the second diode to ground. Alternatively, the method includes connecting a first cathode of the first diode to a power supply, connecting the first anode of the first diode to the first cathode of the second diode, and connected the second anode of the second cathode to the metal line-Moreover, the method may include connecting a first antenna diode circuit between the metal line and ground, and connecting a second diode circuit between the metal line and the power supply.

A computer aided design program may be used to insert the first and second diodes into a circuit design. The computer aided design program may insert the first and second diodes on a metal line that exceeds a predefined ratio of metal area to polysilicon gate area. The method may also include locating the first diode and the second diode on a wafer so as to minimize a single particle passing through both the first and second diodes.

These as well as other aspects and advantages will become apparent to those of ordinary skill in the art by reading the following detailed description, with reference where appropriate to the accompanying drawing. Further, it is understood that this summary is merely an example and is not intended to limit the scope of the invention as claimed.

Presently preferred embodiments are described below in conjunction with the appended drawing figures, wherein.

Fig. 1 is a circuit diagram that depicts an antenna diode circuit that is immune to SET, according to an example; and

Fig. 2 is a circuit diagram that depicts an antenna diode circuit that is immune to SET, according to another example.

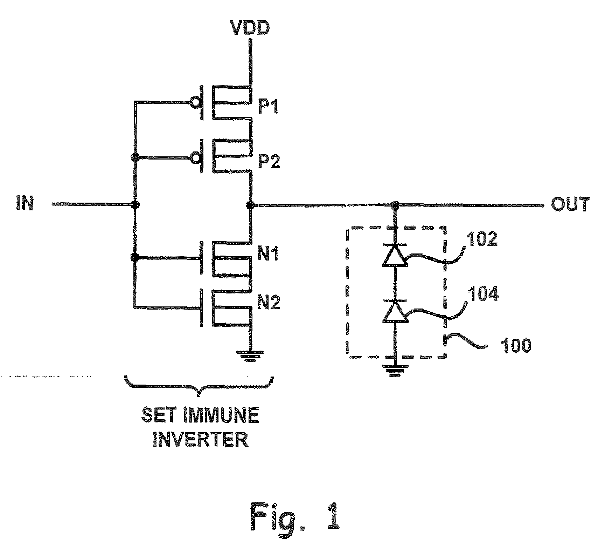

Fig. 1 is a circuit diagram that that depicts an antenna diode circuit 100 that is immune to SET. In this example, the antenna diode circuit 100 is connected to a signal line (i.e., OUT) that is driven by a circuit that has been designed to be SET immune. Fig. 1 depicts the SET immune circuit as an SET immune inverter; however, the antenna diode circuit 100 may be connected to any signal line.

The antenna diode circuit 100 includes a first diode 102 connected in series to a second diode 104. The antenna diode circuit 100 is connected between the signal line and ground. A cathode of the first diode 102 is connected to the signal line. An anode of the first diode 102 is connected to a cathode of the second diode 104. An anode of the second diode 104 is connected to ground. The antenna diode circuit 100 connected between the signal line and ground protects the signal line during fabrication without introducing an SET weakness in a circuit connected to the signal line, such as the SET immune inverter depicted in Fig. 1.

The antenna diode circuit 100 prevents an upset from a single particle strike. If a particle strike hits the first diode 102, the second diode 104 protects the signal line. More specifically, a particle hit on the first diode 102 may cause current flow in the first diode 102. However, the second diode 104 may limit the current flow, which limits any change in voltage on the signal line as a result of the particle hit. In a similar manner, the first diode 102 protects the signal line if a particle strike hits the second diode 104.

It is unlikely that a particle would strike both the first and second diodes 102, 104 at the same time. However, during the design and/or layout process, the first and second diodes 102, 104 may be located on a wafer so as to minimize the chances of a single particle passing through both the diodes 102, 104. For example, the first diode 102 may be laid out on the chip in such a manner so as to not be aligned with the second diode 104 or to be otherwise separated from the second diode 104.

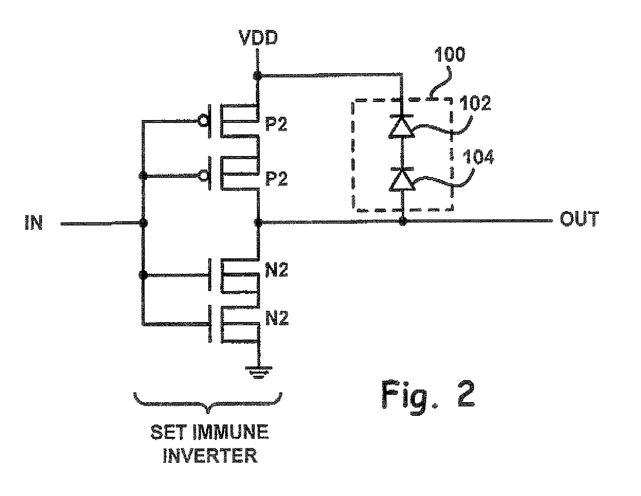

In another example, the antenna diode circuit 100 may be connected between the signal line and a power supply as depicted in Fig. 2. Figure 2 depicts the antenna diode circuit 100 connected to VDD, but the antenna diode circuit 100 could be connected to other power supplies as well. Additionally, a first antenna diode circuit 100 may be connected between the signal line and ground, while a second antenna diode circuit 100 is connected between the signal line and the power supply.

The antenna diode circuit 100 may be included in a CAD tool kit. The CAD software may treat the antenna diode circuit 100 as a "black box." During a circuit design flow, the antenna diode circuit 100 may be inserted on metal lines automatically by the CAD software as needed. For example, the antenna diode circuit 100 may be automatically inserted on a metal line that exceeds a predefined ratio of metal area to polysilicon gate area. Other rules may be used to identify where to insert the antenna diode circuit 100 in a circuit design.

As a result of connecting the antenna diode circuit 100 to a metal line, the metal line may be protected from charge accumulation during wafer fabrication without introducing an SET weakness to a circuit connected to the metal line. This is especially beneficial when the circuit driving the metal line has been hardened against SET. As a result, the antenna diode circuit 100 may be used in environments that expose the antenna diode circuit 100 to radiation.

It should be understood that the illustrated embodiments are examples only and should not be taken as limiting the scope of the present invention. The claims should not be read as limited to the described order or elements unless stated to that effect. Therefore, all embodiments that come within the scope and spirit of the following claims and equivalents thereto are claimed as the invention.

## Claims

1. An antenna diode circuit, comprising in combination:
a first diode having a first cathode and a first mode, wherein the first cathode is connected to a signal line; and
a second diode having a second cathode and a second anode, wherein the second cathode is connected to the first anode, and wherein the second anode is connected to ground.

2. The antenna diode circuit of claim 1, wherein the signal line is a metal line to be protected against charge accumulation during fabrication.

3. The antenna diode circuit of claim 1, wherein the signal line is driven by a circuit that is hardened against single event transients.

4. The antenna diode circuit of claim 1, wherein a device layout program inserts the antenna diode circuit on the signal line if the signal line exceeds a predefined ratio of metal area to polysilicon gate area.

5. The antenna diode of claim 1, wherein the first diode and the second diode are located on a wafer so as to minimize a single particle passing through both the first and second diodes.

6. An antenna diode circuit, comprising in combination:
a first diode having a first cathode and a first anode, wherein the first cathode is connected to a power supply; and
a second diode having a second cathode and a second anode, wherein the second cathode is connected to the first anode, and wherein the second anode is connected to a signal line.

7. The antenna diode circuit of claim 6, wherein the signal line is a metal line to be protected against charge accumulation during fabrication.

8. The antenna diode circuit of claim 6, wherein the signal line is driven by a circuit that is hardened against single event transients.

9. The antenna diode circuit of claim 6, wherein a device layout program inserts the antenna diode circuit on the signal line if the signal line exceeds a predefined ratio of metal area to polysilicon gate area.

10. The antenna diode of claim 6, wherein the first diode and the second diode are located on a wafer so as to minimize a single particle passing through both the first and second diodes.
